# EUROPÄISCHE PATENTSCHRIFT

(11) **EP 3 232 569 B1**
(45) Veröffentlichungstag und Bekanntmachung des Hinweises auf die Patenterteilung: **22.04.2020**
(21) Anmeldenummer: 17166254.7
(22) Anmeldetag: 29.11.2012
(51) Int. Cl.: H03H 9/145, H03H 9/02

(54) **AKUSTISCHES OBERFLÄCHENWELLENBAUELEMENT UND VERFAHREN ZU SEINER HERSTELLUNG**
ACOUSTIC SURFACE WAVE ELEMENT AND METHOD FOR ITS PRODUCTION
ÉLÉMENT DE CONSTRUCTION ONDULÉ DE SURFACE ACOUSTIQUE ET SON PROCÉDÉ DE FABRICATION

(30) Priorität: 06.12.2011 DE 102011087820
(43) Veröffentlichungstag der Anmeldung: 18.10.2017
(62) Teilanmeldung aus: 12812182.9
(73) Patentinhaber: Leibniz-Institut für Festkörper- und Werkstoffforschung Dresden e.V., 01069 Dresden (DE)
(72) Erfinder: MENZEL, Siegfried, 04924 Lausitz (DE); WINKLER, Andreas, 01187 Dresden (DE)
(74) Vertreter: Rauschenbach, Marion

(56) Entgegenhaltungen:
- EP-A2- 1 467 484
- WO-A2-03/085827
- DE-A1-102007 012 384
- US-A1- 2004 233 020
- US-A1- 2008 067 891
- T. CHUDOBA ET AL: "Determination of elastic properties of thin films by indentation measurements with a spherical indenter", SURFACE AND COATINGS TECHNOLOGY, Bd. 127, Nr. 1, 1. Mai 2000 (2000-05-01), Seiten 9-17, XP055421057, AMSTERDAM, NL ISSN: 0257-8972, DOI: 10.1016/S0257-8972(00)00552-1
- ZHAO JIE-HUA ET AL: "Simultaneous measurement of Young's modulus, Poisson ratio, and coefficient of thermal expansion of thin films on substrates", JOURNAL OF APPLIED PHYSICS, AMERICAN INSTITUTE OF PHYSICS, US, Bd. 87, Nr. 3, 1. Februar 2000 (2000-02-01), Seiten 1575-1577, XP012049456, ISSN: 0021-8979, DOI: 10.1063/1.372054

## Beschreibung

Die Erfindung bezieht sich auf das Gebiet der Elektrotechnik/Akustoelektronik und betrifft ein akustisches Oberflächenwellen (surface acoustic wave, SAW)-Bauelement, wie es beispielsweise als Filterbauelement in mobilen Telefonen, als Sensor oder als Aktor zum Einsatz kommen kann, und ein Verfahren zu seiner Herstellung.

Die SAW-Technologie hat in den letzten Jahren eine breite Anwendung gefunden. Da im Vergleich zu elektromagnetischen Wellen die Wellenlänge akustischer Oberflächenwellen um mehrere Größenordnungen kürzer ist (ca. Faktor 10⁵ bei vergleichbarer Frequenz), kann die SAW-Technologie insbesondere vorteilhaft zur Miniaturisierung von Bauelementen, Baugruppen oder Geräten eingesetzt werden. Dies betrifft insbesondere Hochfrequenzfilter (SAW-Filter) für mobile Telefone, sowie Sensoren oder Aktoren. Ein großer Vorteil von SAW-Bauelementen im Vergleich zu elektronischen Halbleiterbauelementen besteht u.a. auch darin, dass bei Verwendung von temperaturbeständigen Materialien ein wesentlich größerer Einsatztemperaturbereich (bis über 900°C) abgedeckt werden kann (R.C. Turnera, et al: Applied Acoustics Vol. 41, 4 (1994) 299-324; M.N. Hamidon, et al: Sensors and Actuators A 123-124 (2005) 403-407). Für Anwendungen in komplexen elektronischen Schaltungen oder Netzwerken sollen SAW-Bauelemente generell eine geringe Einfügedämpfung, eine hohe Güte und Zuverlässigkeit, sowie insbesondere eine hohe Leistungsbeständigkeit und Lebensdauer aufweisen.

Zwei bekannte Beispiele für SAW-Bauelemente sind die Verzögerungsstrecke und der Resonator. Nachfolgend wird anhand einer Verzögerungsstrecke die Wirkungsweise der SAW-Bauelemente erläutert. Eine Verzögerungsstrecke besteht aus zwei voneinander getrennt angeordneten Interdigitalwandlern (Interdigital Transducer, IDT). Ein IDT ist eine Anordnung kammförmig ineinander greifender Metallstreifen (Fingerelektroden), die mit Hilfe von Strukturierungsverfahren in Planartechnologie (z.B. Nass- oder Trockenätzverfahren oder Lift-Off-Technik) hergestellt werden. Die Fingerelektroden eines jeden IDT sind alternierend elektrisch über Verbindungsleitungen (bus-bars) mit jeweils einer Kontaktfläche (Pad) verbunden. Der Bereich, in dem die kammförmigen Fingerelektroden ineinander greifen, wird Apertur genannt. Durch Anlegen einer elektrischen Wechselspannung (meist hochfrequente Spannung, HF-Spannung) an die beiden Kontaktflächen des einen IDT (Eingangswandler) wird zwischen den jeweils benachbarten Fingerelektroden ein elektrisches Feld erzeugt. Über den inversen piezoelektrischen Effekt wird das Substratmaterial zwischen den Elektroden in den Halbperioden abwechselnd gestaucht bzw. gestreckt, wodurch eine akustische (mechanische) Welle an der Substratoberfläche nach beiden Seiten des Eingangswandlers ausgesandt wird. Bei entsprechender Winkelausrichtung des IDT auf dem Piezosubstrat, d.h. bei Anordnung der Längsachse der Fingerelektroden senkrecht zu der an der Substratoberfläche liegenden maximalen Geschwindigkeitskomponente des Substrates, wird die akustische Welle vornehmlich entlang der Substratoberfläche (surface acoustic wave, SAW) und senkrecht zu den beiden Seiten der Fingerelektroden abgestrahlt. Da die SAW ihrerseits aufgrund des piezoelektrischen Effektes ein elektrisches Feld mitführt, kann dieses elektrische Feld von einem zweiten IDT (Ausgangswandler) über den piezoelektrischen Effekt wieder in eine elektrische Spannung umgewandelt werden. Dieser Prozess der Umwandlung von mechanischer in elektrische Energie und umgekehrt ist umso effizienter, je besser u.a. die Maßhaltigkeit der Elektrodenfingeranordnung ist und damit - aufgrund der Gültigkeit der Wellengesetze - die Bedingungen für eine konstruktive Überlagerung (im Gegensatz zur destruktiven Überlagerung oder Auslöschung) der von den einzelnen Fingerpaaren erzeugten Teilwellen gegeben sind. Im einfachsten und am häufigsten verwendeten Fall entspricht der Mittenabstand benachbarter Fingerelektroden unterschiedlichen elektrischen Potenzials der halbe Wellenlänge (λ/2) und die Breite der Elektroden sowie der Zwischenräume zwischen den Elektroden einem Viertel der Wellenlänge (λ/4).

Die so gestalteten IDT sind in bekannten SAW-Bauelementen direkt mit der Oberfläche des piezoelektrischen Substratmaterials verbunden. Als piezoelektrisches Substrat werden dabei meist Einkristallwafer mit einem bestimmten Kristallschnitt oder piezoelektrische Dünnschichten auf einem Trägermaterial (z.B. oxidierter Si-Wafer) verwendet. Infolge der direkten Abscheidung des Elektrodenmaterials als leitfähige Dünnschicht auf das meist vorbehandelte und mit einer dünnen Haftvermittlerschicht versehene piezoelektrische Substrat haften diese Schichten auf dessen Oberfläche über einen physikalischen oder chemischen Zusammenhalt von piezoelektrischem Substrat und Metallschicht (mechanische und spezifische Adhäsion, physikalische oder chemische Adsorption) (K. L. Mittal: Electrocomponent Science and Technology, 1976, Vol. 3, pp. 21-42).

Bei den bekannten SAW-Technologien ist eine gute Haftung zwischen piezoelektrischem Substrat und Metallschicht von großem Vorteil für die Fixierung der Fingeranordnung an der Substratoberfläche und für die effiziente Einkopplung des elektrischen Feldes in das Substrat. Andererseits bewirkt sie jedoch bekanntermaßen eine vollständige Übertragung der durch die SAW generierten, zeitabhängigen lokalen Dehnung (Wechsel aus Druck- und Zugbelastung) der Substratoberfläche (F. Kubat: Theoretische und experimentelle Untersuchungen zur Leistungsfähigkeit von Oberflächenwellen-Filtern, Dissertation Albert-Ludwigs-Universität Freiburg, Freiburg 2004). Die damit verbundene, zeitlich veränderliche mechanische Spannungsverteilung in den Fingerelektroden kann infolge einer Kombination von Rissbildung (als Folge von Ermüdungseffekten) und Materialtransport (als Folge von Drift-Diffusion) bei hohen eingekoppelten Leistungen und folglich hohen SAW-Amplituden zur irreversiblen Degradation der Fingerelektroden (Mikrostrukturschädigung) und somit des elektrischen Signalverhaltens (z.B. irreversible Frequenzverschiebung eines Filterbauelements) bis zum Ausfall des SAW-Bauelements führen. Bei schlechter oder partiell schlechter Haftung der Fingerelektroden auf dem piezoelektrischen Substrat ist eine vollständige oder teilweise Delamination der Elektroden bis hin zu Abplatzungen infolge Mikrorissbildung möglich. Mikrorissbildung, Materialtransport (d.h. Loch- und Hügelbildung) und Delamination oder Abplatzungen zerstören die Mikrostruktur und die Geometrie der Fingeranordnung und somit das elektrische Signalverhalten des SAW-Bauelements.

Die Intensität der irreversiblen Degradation der SAW-Bauelemente ist von mehreren Faktoren abhängig, insbesondere der Art des verwendeten Substrat- und Elektrodenmaterials inklusive dessen Mikrostruktur und Textur, der Belastung, d.h. dem Spannungszustand in den Elektroden als Überlagerung von intrinsischer Spannung und SAW-Lastspannung, der Betriebstemperatur und den Umgebungsbedingungen (Umgebungsatmosphäre). Bei extrem großen Spannungsamplituden oder Temperaturgradienten kann durch Rissbildung auch das piezoelektrische (und oft zusätzlich pyroelektrische) Substrat zerstört werden.

Weiterhin ist aus der DE 11 2005 002 562 T5 eine Vorrichtung zur Erregung einer akustischen Oberflächenwelle bekannt, bei der Interdigitalwandler zwischen ein piezoelektrisches und nichtpiezoelektrisches Element angeordnet werden und Vorbelastungseinrichtungen einen Druck auf das piezoelektrische Element gegen das nichtpiezoelektrische Element mit Hilfe der Interdigitalwandler aufbringen, wodurch eine mechanische Kopplung zwischen piezoelektrischem Element und Interdigitalwandlern realisiert wird.

Aus der DE 102 06 369 A1 ist eine Elektrodenstruktur mit verbesserter Leistungsverträglichkeit und ein Verfahren zu ihrer Herstellung bekannt. Danach wird zwischen ein piezoelektrisches Substrat und die Elektrodenstruktur eine mechanisch stabile Anpassungsschicht angeordnet, die eine gute Haftung aufweisen soll und aus Materialien ausgeführt sein soll, die eine geringere Materialermüdung und eine höhere Bruch-Dehngrenze aufweisen, als Al oder Al-Legierungen der bisherigen Elektrodenstrukturen.

Ebenfalls ist aus der DE 10 2008 001 000 A1 ein Schichtsystem für Elektroden bekannt, welches aus einem piezoelektrischen Substrat mit darauf befindlichen oder im Substrat eingebetteten Streifenstrukturen aus einem Kompositmaterial besteht, wobei das Kompositmaterial aus einem metallischen Matrixmaterial mit einer Einlagerungsphase aus Kohlenstoffnanostrukturen besteht.

Aus EP1467484 A2, US 2008/067891 A1 sowie aus WO 03/085827 A2 sind ebenfalls Beispiele von akustischen Oberflächenwellen bekannt.

Die Aufgabe der vorliegenden Erfindung ist es, ein akustisches Oberflächenwellenbauelement anzugeben, bei welchem die Degradation der IDT deutlich herabgesetzt ist und damit eine deutlich längere Lebensdauer des akustischen Oberflächenwellenbauelements erreicht wird, sowie ein einfaches und kostengünstiges Verfahren zur Herstellung solcher akustischer Oberflächenwellenbauelemente anzugeben.

Die Aufgabe wird durch die in dem Anspruch 1 angegebene Erfindung gelöst. Vorteilhafte Ausgestaltungen sind Gegenstand der Unteransprüche.

Das erfindungsgemäße akustische Oberflächenwellenbauelement besteht mindestens aus einem piezoelektrischen Material, Interdigitalwandlern und elektrischen Kontaktierungen, wobei zwischen piezoelektrischem Material und Interdigitalwandlern mindestens eine dehnungsabsorbierende, elastische Schicht mindestens teilweise im Bereich der Apertur der Interdigitalwandler vorhanden ist, wobei die dehnungsabsorbierende, elastische Schicht minimal durch die Rauheit der Oberflächen der Interdigitalwandler und des piezoelektrischen Materials und maximal durch einen Abstand von 1000 nm begrenzt ist, und wobei die dehnungsabsorbierende, elastische Schicht aus einem Polymer oder einem Fotolack besteht, und wobei die dehnungsabsorbierende, elastische Schicht aus einem Material mit einem niedrigeren mittleren E-Modul als dem des Materials der Interdigitalwandler besteht.

Vorteilhafterweise ist die dehnungsabsorbierende, elastische Schicht elektrisch leitfähig.

Ebenfalls vorteilhafterweise ist das piezoelektrische Material ein flächiges Material, eine Platte, ein Wafer oder eine Schicht oder eine Beschichtung auf einer Unterlage. Weiterhin von Vorteil ist es, wenn die elastische Schicht aus einem Material besteht, dessen mittlerer E-Modul maximal halb so groß ist, wie der mittlere E-Modul des Materials der Interdigitalwandler.

Und auch von Vorteil ist es, wenn die dehnungsabsorbierende Schicht aus Polystyrol oder Polycarbonat besteht und/oder bei dem die mindestens dehnungsabsorbierende Schicht zwischen den Interdigitalwandlern und dem piezoelektrischen Material als durchgehende Schicht, als strukturierte Schicht oder als teilweise Beschichtung vorhanden ist.

Bei dem Verfahren zur Herstellung eines akustischen Oberflächenwellenbauelementes werden auf ein nichtpiezoelektrisches Material mindestens eine dehnungsabsorbierende, elastische Schicht aufgebracht und darauf Interdigitalwandler aufgebracht und mit der dehnungsabsorbierenden, elastischen Schicht form- und/oder kraftschlüssig verbunden, die Interdigitalwandler elektrisch kontaktiert und nachfolgend das piezoelektrische Material mindestens teilweise in Kontakt mit mindestens dem nichtpiezoelektrischen Material gebracht.

Vorteilhafterweise wird/werden die mindestens eine mindestens dehnungsabsorbierende, elastische Schicht/en durch physikalische Gasphasenabscheidung (PVD, Aufdampfen, Sputtern), chemische Gasphasenabscheidung (CVD, PECVD, MWCVD), Atomlagenabscheidung (ALD), thermische Oxidation oder Nitrierung, Ionenimplantation, Elektrosprayionisation, durch Abscheidung aus Dispersionen oder Lösungen oder durch elektrochemische Abscheidung aufgebracht und mit fotolithografischen Verfahren oder durch Direktschreib-Lithografie strukturiert. Vorteilhafterweise werden als fotolithografische Verfahren Lift-Off-Verfahren oder Ätzverfahren eingesetzt.

Vorteilhafterweise werden auf ein nichtpiezoelektrisches Material Interdigitalwandler mit weiteren Zwischenschichten und/oder Deckschichten aufgebracht.

Weiterhin vorteilhafterweise werden die weitere Zwischenschicht oder die weiteren Zwischenschichten und/oder Deckschichten mittels Atomlagenabscheidung (Atomic Layer Deposition), Gasphasensilanisierung, mittels Oxidation oder Nitrierung oder Karbidbildung und nachfolgender Wärmebehandlung der Interdigitalwandler in sauerstoffhaltiger oder stickstoffhaltiger oder kohlenstoffhaltiger Atmosphäre aufgebracht.

Vorteilhaft ist es auch, wenn nichtpiezoelektrische Schichten aufgebracht werden, die aus SiO₂ oder Al₂O₃ oder Si₃N₄ bestehen.

Mit der erfindungsgemäßen Lösung ist es erstmals möglich akustische Oberflächenwellenbauelemente anzugeben, bei welchen die Degradation der Interdigitalwandler (IDT) deutlich herabgesetzt und die Lebensdauer der Bauelemente deutlich verlängert ist, ohne eine Optimierung der verwendeten Materialien vornehmen zu müssen. Dies wird im Wesentlichen erreicht, indem mindestens im Bereich der Apertur der IDT mindestens teilweise eine mindestens eine dehnungsabsorbierende, elastische Schicht, vorteilhafterweise mit niedrigem E-Modul, in diesem Bereich zwischen IDT und piezoelektrischem Material vorhanden ist.

Zwingende Voraussetzung für das erfindungsgemäße akustische Oberflächenwellenbauelement ist, dass der Abstand zwischen IDT und piezoelektrischem Material nicht so groß ist, dass eine Anregung der akustischen Oberflächenwellen nicht mehr erreicht wird. Dies ist im Allgemeinen bei einem Abstand zwischen IDT und piezoelektrischem Material von mehr als 1000 nm der Fall, so dass größere Abstände nicht mehr zu einer sicheren Arbeitsweise des Bauelementes führen.

Die Degradation der IDT infolge Mikrorissbildung oder Loch- und Hügelbildung in SAW-Bauelementen bei hohen HF-Leistungen und folglich hohen SAW-Amplituden wird erfindungsgemäß dadurch deutlich verringert, dass der starre mechanische Verbund zwischen den IDT und dem piezoelektrischen Material gelockert wird und so die Übertragung der lokalen zeitabhängigen mechanischen Dehnung der Materialoberfläche auf die IDT unterdrückt wird.

Der minimale Abstand zwischen den IDT und dem piezoelektrischen Material, also die minimale gesamte Dicke der dehnungsabsorbierenden, elastischen Schicht oder Schichten wird erfindungsgemäß durch die Rauheit der Oberflächen von IDT und piezoelektrischem Material bestimmt, wobei in diesem Fall der IDT in direktem elektrischen Kontakt zum piezoelektrischen Material steht. Er beträgt vorteilhafterweise aber 1 nm bis mehrere 10 nm, jedoch maximal 1000 nm. In jedem Fall soll eine maximal 1000 nm dicke dehnungsabsorbierende, elastische Schicht zwischen IDT und piezoelektrischem Material einerseits und eine maximale Einkopplung des elektrischen Feldes in das piezoelektrische Material ohne Degradation des Materials der IDT andererseits erreicht werden, so dass die gewünschte Frequenzcharakteristik trotz des Abstandes zwischen IDT und piezoelektrischem Material bestmöglich angeregt werden kann.

Das piezoelektrische Material ist vorteilhafterweise ein flächiges Material, eine Platte, ein Wafer oder eine Schicht oder eine Beschichtung auf einer Unterlage. Dies kann beispielsweise ein Einkristallwafer oder eine einkristalline Schicht sein, die auf einem nichtpiezoelektrischen Material abgeschieden werden kann, oder es kann ein polykristallines, piezoelektrisches Schichtmaterial auf einem nichtpiezoelektrischen Material sein.

Als piezoelektrische und nichtpiezoelektrische Materialien sowie als Materialien für die IDT oder für die Kontaktierungen können alle Materialien eingesetzt werden, die nach dem Stand der Technik für derartige akustische Oberflächenwellenbauelemente bekannt sind, wie z.B. LiNbO₃, LiTaO₃, Quarz, AlN, Al, Au, Cu, Pt, Ru u.a.

Die Aufgabe der vorliegenden Erfindung wird erfindungsgemäß gelöst durch die Realisierung mindestens einer - möglichst elektrisch leitfähigen - dehnungsabsorbierenden, elastischen Schicht zwischen dem piezoelektrischen Material und den Interdigitalwandlern. Diese Schicht oder Schichten nehmen die durch die akustischen Oberflächenwellen ausgelöste Dehnung des piezoelektrischen Materials auf und absorbieren sie möglichst vollständig, so dass möglichst keine Dehnung mehr auf das Material der Interdigitalwandler übertragen wird. Vorteilhafterweise wird dies durch eine oder mehrere Schichten erreicht, die elastisch sind und im Vergleich zum Material der IDT einen signifikant niedrigeren E-Modul haben. Diese Schicht oder Schichten sind mindestens im Bereich der Apertur der Interdigitalwandler angeordnet und können dort auch nur teilweise vorhanden sein. So kann beispielsweise diese elektrisch leitfähige, dehnungsabsorbierende, elastische Schicht nur unter dem Bereich der Interdigitalwandler vollständig oder auch nur teilweise, beispielsweise säulenförmig, angeordnet sein.

Dabei ist eine gute Haftung dieser Schicht oder Schichten zum piezoelektrischen Material und zum Material der IDT vorteilhaft, aber in Verbindung mit einer mechanisch stabilen und elektrisch isolierenden Deckschicht nicht zwingend erforderlich.

Nachfolgend wird die Erfindung an einem Ausführungsbeispiel näher erläutert.

### Beispiel 1

Das Beispiel betrifft die Herstellung eines akustischen Oberflächenwellenbauelements in Form einer Verzögerungsstrecke aus zwei in einem lateralen Abstand in SAW-Ausbreitungsrichtung von 0.5 mm angeordneten IDT.

An der Oberfläche eines mittels RCA-Reinigung aktivierten, piezoelektrischen LiNbO₃-Wafers wird eine dehnungsabsorbierende, elastische monomolekulare Silanschicht (durch 5-stündige Inkubation des Wafers bei 80°C in einer 50%igen Lösung von (Hydroxy(Polyethylenoxy)Propyl)Triethoxysilan in Ethanol) erzeugt. Anschließend wird eine Lackmaske für zwei gleichartige IDT (je 0.25 mm x 1 mm, 0.2 mm Apertur), die im Abstand von 0.5 mm zueinander angeordnet sind, und die zugehörigen Kontaktflächen (1 mm x 1 mm) mittels fotolithografischer Verfahren aufgebracht. Darauf werden mittels Elektronenstrahlverdampfens eine 300 nm dicke Schicht aus Al mit einer 5 nm dicken Ti-Zwischenschicht abgeschieden werden. Nachfolgend wird mittels Lift-Off-Technik die Lackmaske mit den darauf befindlichen Metallschichten entfernt, so dass zwei strukturierte IDT mit Kontaktflächen vorliegen.

Die Degradation des Materials des IDT auf der nur wenige nm dicken, dehnungsabsorbierenden, elastischen Zwischenschicht auf dem piezoelektrischen Substrat ist in diesem Beispiel, verglichen mit einem direkt auf dem piezoelektrischen Substrat aufgebrachten IDT um den Faktor 5 herabgesetzt. Damit weist das Oberflächenwellenbauelement eine deutlich längere Lebensdauer auf.

## Patentansprüche

1. Akustisches Oberflächenwellenbauelement, bestehend mindestens aus einem piezoelektrischen Material, Interdigitalwandlern und elektrischen Kontaktierungen, wobei zwischen piezoelektrischem Material und Interdigitalwandlern mindestens eine dehnungsabsorbierende, elastische Schicht mindestens teilweise im Bereich der Apertur der Interdigitalwandler vorhanden ist, wobei die dehnungsabsorbierende, elastische Schicht minimal durch die Rauheit der Oberflächen der Interdigitalwandler und des piezoelektrischen Materials und maximal durch einen Abstand von 1000 nm begrenzt ist, und wobei die dehnungsabsorbierende, elastische Schicht aus einem Polymer oder einem Fotolack besteht, und wobei die dehnungsabsorbierende, elastische Schicht aus einem Material mit einem niedrigeren mittleren E-Modul als dem des Materials der Interdigitalwandler besteht.

2. Akustisches Oberflächenwellenbauelement nach Anspruch 1, bei dem die dehnungsabsorbierende Schicht elektrisch leitfähig ist.

3. Akustisches Oberflächenwellenbauelement nach Anspruch 1, bei dem das piezoelektrische Material ein flächiges Material, eine Platte, ein Wafer oder eine Schicht oder eine Beschichtung auf einer Unterlage ist.

4. Akustisches Oberflächenwellenbauelement nach Anspruch 1, bei dem die elastische Schicht aus einem Material besteht, dessen mittlerer E-Modul maximal halb so groß ist, wie der mittlere E-Modul des Materials der Interdigitalwandler.

5. Akustisches Oberflächenwellenbauelement nach Anspruch 1, bei dem die dehnungsabsorbierende Schicht aus Polystyrol oder Polycarbonat besteht und/oder bei dem die mindestens dehnungsabsorbierende Schicht zwischen den Interdigitalwandlern und dem piezoelektrischen Material als durchgehende Schicht, als strukturierte Schicht oder als teilweise Beschichtung vorhanden ist.

## Claims

1. Surface acoustic wave component consisting at least of a piezoelectric material, interdigital transducers and electrical contacts, wherein at least one strain-absorbing, elastic layer is present between the piezoelectric material and the interdigital transducers, at least partly in the region of the aperture of the interdigital transducers, wherein the strain-absorbing, elastic layer is defined at least by the roughness of the surfaces of the interdigital transducers and of the piezoelectric material and at most by a spacing of 1000 nm, and wherein the strain-absorbing, elastic layer consists of a polymer or a photoresist, and wherein the strain-absorbing, elastic layer consists of a material with a lower average modulus of elasticity than that of the material of the interdigital transducers.

2. Surface acoustic wave component according to Claim 1, in which the strain-absorbing layer is electrically conductive.

3. Surface acoustic wave component according to Claim 1, in which the piezoelectric material is a flat material, a panel, a wafer or a layer or a coating on a base.

4. Surface acoustic wave component according to Claim 1, in which the elastic layer consists of a material whose average modulus of elasticity is at most half that of the average modulus of elasticity of the material of the interdigital transducers.

5. Surface acoustic wave component according to Claim 1, in which the strain-absorbing layer consists of polystyrene or polycarbonate and/or in which the at least one strain-absorbing layer is present in the form of a continuous layer, in the form of a structured layer or in the form of a partial coating between the interdigital transducers and the piezoelectric material.

## Revendications

1. Composant acoustique à ondes de surface, composé d'au moins un matériau piézoélectrique, de convertisseurs interdigitaux et d'éléments de mise en contact électriques, au moins une couche élastique absorbant la dilatation se trouvant entre le matériau piézoélectrique et les convertisseurs interdigitaux, au moins partiellement dans la zone de l'ouverture des convertisseurs interdigitaux, la couche élastique absorbant la dilatation étant délimitée au minimum par la rugosité des surfaces des convertisseurs interdigitaux et du matériau piézoélectrique et au maximum par un écart de 1000 nm, et la couche élastique absorbant la dilatation se composant d'un polymère ou d'un vernis photosensible, et la couche élastique absorbant la dilatation se composant d'un matériau ayant un module d'élasticité moyen plus faible que celui du matériau des convertisseurs interdigitaux.

2. Composant acoustique à ondes de surface selon la revendication 1, avec lequel la couche élastique absorbant la dilatation est électriquement conductrice.

3. Composant acoustique à ondes de surface selon la revendication 1, avec lequel le matériau piézoélectrique est un matériau plat, tel qu'une plaque, une galette ou une couche ou encore un revêtement sur un support.

4. Composant acoustique à ondes de surface selon la revendication 1, avec lequel la couche élastique se compose d'un matériau dont le module d'élasticité est au maximum égal à la moitié du module d'élasticité moyen du matériau des convertisseurs interdigitaux.

5. Composant acoustique à ondes de surface selon la revendication 1, avec lequel la couche élastique absorbant la dilatation se compose de polystyrène ou de polycarbonate et/ou avec lequel l'au moins une couche absorbant la dilatation entre les convertisseurs interdigitaux et le matériau piézoélectrique se présente sous la forme d'une couche continue, sous la forme d'une couche structurée ou sous la forme d'un revêtement partiel.
